(19) Europäisches Patentamt
European Patent Office
Office européen des brevets

(11) **EP 1 127 379 B1**

(12) **EUROPÄISCHE PATENTSCHRIFT**

(45) Veröffentlichungstag und Bekanntmachung des Hinweises auf die Patenterteilung:
**02.06.2010   Patentblatt 2010/22**

(51) Int Cl.:
***H01L 29/78*** (2006.01)     ***H01L 29/739*** (2006.01)
***H01L 29/10*** (2006.01)

(21) Anmeldenummer: **99953538.8**

(22) Anmeldetag: **19.08.1999**

(86) Internationale Anmeldenummer:
**PCT/DE1999/002604**

(87) Internationale Veröffentlichungsnummer:
**WO 2001/015235 (01.03.2001 Gazette 2001/09)**

(54) **VERTIKAL AUFGEBAUTES LEISTUNGSHALBLEITERBAUELEMENT**

VERTICALLY STRUCTURED SEMICONDUCTOR POWER MODULE

COMPOSANT A SEMI-CONDUCTEUR DE PUISSANCE A STRUCTURE VERTICALE

(84) Benannte Vertragsstaaten:
**DE FR GB IE IT**

(43) Veröffentlichungstag der Anmeldung:
**29.08.2001   Patentblatt 2001/35**

(73) Patentinhaber: **Infineon Technologies AG**
**85579 Neubiberg (DE)**

(72) Erfinder:
 • **WEBER, Hans**
  **D-83404 Ainring (DE)**
 • **WILLMEROTH, Armin**
  **D-86163 Augsburg (DE)**
 • **DEBOY, Gerald**
  **D-82008 Unterhaching (DE)**
 • **STENGL, Jens-Peer**
  **D-82284 Grafrath (DE)**

(74) Vertreter: **Kottmann, Heinz Dieter et al**
**Patentanwälte**
**MÜLLER & HOFFMANN,**
**Innere Wiener Strasse 17**
**81667 München (DE)**

(56) Entgegenhaltungen:
 **EP-A- 0 061 551    EP-A- 0 222 326**
 **EP-A- 0 503 605    DE-A- 19 731 495**

 • **LASKA T ET AL: "A 2000 V-NON-PUNCH-THROUGH-IGBT WITH DYNAMICAL PROPERTIES LIKE A 1000 V-IGBT" INTERNATIONAL ELECTRON DEVICES MEETING,US,NEW YORK, IEEE, Bd. -, 1990, Seiten 807-810, XP000279629**
 • **LASKA T ET AL: "ULTRATHIN-WAFER TECHNOLOGY FOR A NEW 600V-NPT-IGBT" IEEE INTERNATIONAL SYMPOSIUM ON POWER SEMICONDUCTOR DEVICES AND ICS,US,NEW YORK, NY: IEEE, Bd. CONF. 9, 1997, Seiten 361-364, XP000800221 ISBN: 0-7803-3994-0 in der Anmeldung erwähnt**

EP 1 127 379 B1

**Beschreibung**

Die vorliegende Erfindung betrifft ein vertikal aufgebautes Leistungshalbleiterbauelement mit:

- einem eine erste Hauptoberfläche und eine zur ersten Hauptoberfläche gegenüberliegende zweite Hauptoberfläche aufweisenden Halbleiterkörper des einen Leitungstyps,

- einer in die erste Hauptoberfläche eingebrachten Body-Zone des anderen, zum einen Leitungstyp entgegengesetzten Leitungstyps,

- einer in der Body-Zone vorgesehenen Zone des einen Leitungstyps,

- einer die Zone des einen Leitungstyps und die Body-Zone kontaktierenden ersten Elektrode,

- einer auf der zweiten Hauptoberfläche vorgesehenen zweiten Elektrode und

- einer oberhalb der Body-Zone angeordneten und von dieser durch eine Isolierschicht getrennten Gateelektrode.

Bei Halbleiterleistungsbauelementen besteht die Anforderung, auf kleinster Fläche einen möglichst großen Strom zu transportieren. Zur Optimierung des Kanalweiten/Kanallängen- bzw. -flächen-Verhältnisses werden daher Leistungshalbleiterbauelemente aus einer Vielzahl von parallel geschalteten Zellen aufgebaut, bei denen der Strompfad jeweils in Vertikalrichtung, also von der einen Hauptoberfläche des Halbleiterkörpers zu der anderen Hauptoberfläche von diesem verläuft. Damit wirkt das gesamte, unter den jeweiligen eigentlichen Zellen gelegene Halbleitermaterial, also hin bis zu dem auf der anderen Hauptoberfläche gelegenen Rückseitenanschluß, als aktives Volumen.

Im folgenden wird davon ausgegangen, daß es sich bei dem Leistungshalbleiterbauelement um einen n-Kanal-Leistungs-MOS-Feldeffekttransistor handelt, bei dem sich die Source- und Gateanschlüsse auf der einen Hauptoberfläche des Halbleiterkörpers, der Chipoberseite, und der Drainanschluß auf der anderen Hauptoberfläche des Halbleiterkörpers, der Chipunterseite befinden.

Die folgenden Überlegungen sind aber ohne weiteres auch auf andere Leistungshalbleiterbauelemente, wie beispielsweise IGBTs (Bipolartransistor mit isoliertem Gate) usw. anwendbar.

Bei einem Leistungshalbleiterbauelement wird die an diesem liegende Spannung dadurch aufgenommen, daß sich nahegelegene p- und n-leitende Bereiche gegenseitig von beweglichen Ladungsträgern ausräumen, so daß eine Raumladungszone entsteht. Bei dem n-Kanal-Leistungs-MOS-Feldeffekttransistor finden so in einer p-leitenden Wanne entstandene ortsfeste Ladungen ihre "Spiegelladungen" in erster Linie in einer vertikal benachbarten n-leitenden Schicht, die zumeist durch Epitaxie hergestellt ist. Das Maximum des elektrischen Feldes tritt immer am pn-Übergang zwischen der p-leitenden Wanne und dem Halbleiterkörper auf. Ein elektrischer Durchbruch wird erreicht, wenn dieses elektrische Feld eine materialspezifische kritische Feldstärke $E_c$ überschreitet: dann führen nämlich Multiplikationseffekte zur Erzeugung von freien Ladungsträgerpaaren, so daß der Sperrstrom plötzlich stark ansteigt. Da nun Ladungen bekanntlich die Quellen von jedem elektrischen Feld sind, kann dieser kritischen Feldstärke $E_c$ gemäß der ersten Maxwell'schen Gleichung eine äquivalente Durchbruchsflächenladung $Q_c$ zugeordnet werden. Für Silizium gelten beispielsweise $E_c$ = 2,0 ... 3,0 x $10^5$ V/cm und $Q_c$ = 1, 3 - 1,9 x $10^{12}$ Ladungsträger $cm^{-2}$. Die exakte Größe von $Q_c$ ist dabei abhängig von der Höhe der Dotierung.

Der Spannungsabbau in einem Leistungshalbleiterbauelement, der im Zellenfeld im tieferliegenden Volumen des Halbleiterkörpers erfolgt, muß auch gegen dessen Rand hin definiert werden, wobei hier ein Verlauf in Horizontalrichtung angestrebt wird. Um dies zu erreichen, werden gewöhnlich aufwendige, oberflächenpositionierte Äquipotentialstrukturen angewandt.

Das Durchbruchsverhalten von Leistungshalbleiterbauelementen kann in statischen Messungen beurteilt werden. Wesentlich aussagekräftiger ist jedoch ein "Avalanchetest", bei dem neben dem eigentlichen Durchbruch auch das Schaltverhalten ausgetestet wird. Dabei werden unterschiedliche Bereiche der sicheren Betriebsfläche, die auch als SOA-Fläche bezeichnet wird, während eines Tests durchlaufen. Zweck derartiger Messungen ist es, für Kundenanwendungen den "schlechtesten Fall" zu simulieren. Um den verschiedenen Anforderungen zu genügen, muß ein Leistungshalbleiterbauelement insbesondere die folgenden Forderungen erfüllen:

(a) Bei einem elektrischen Durchbruch fließt, verursacht durch Ladungsträgermultiplikation, ein vom äußeren Schaltkreis eingeprägter hoher Strom. Um das Leistungshalbleiterbauelement nicht zu zerstören, dürfen aber keine allzu hohen Stromdichten auftreten. Das heißt, der Durchbruchstrom muß sich möglichst gleichmäßig über den Halbleiterkörper bzw. Chip verteilen.

Diese Forderung ist aber nur dann erfüllt, wenn das eigentliche Zellenfeld den größten Anteil dieses Durchbruchstromes führt. Bricht nämlich das Leistungshalbleiterbauelement in seiner Randstruktur bei niedrigeren Spannungen durch als das Zellenfeld, so führt dies in den meisten Fällen zu irreversiblen thermischen Schädigungen des Halbleiterkörpers bzw.

Chips. Die Sperrspannungsdifferenz zwischen dem Randbereich und dem Zellenfeld muß also so groß ausgelegt werden, daß Fertigungsschwankungen den Durchbruch nicht in Richtung auf den Randbereich verschieben. Generell läßt sich also sagen, daß die Spannungsfestigkeit des Randbereiches höher sein muß als diejenige des Zellenfeldes.

(b) Infolge von Fertigungsschwankungen setzt der elektrische Durchbruch niemals homogen über dem gesamten Halbleiterkörper bzw. Chip ein. Vielmehr wird der Durchbruch durch die "schwächste" Zelle definiert. Um nun zu einer Homogenisierung über das Zellenfeld zu kommen, muß die Spannung an einer solchen schwächsten Zelle mit anwachsendem Durchbruchstrom höher werden.

Denn dadurch gelangen auch andere Zellen in den Durchbruch, die nun ihrerseits wieder in der Spannung "schieben". Auf diese Weise verteilt sich der "Avalanchestrom" gleichmäßig über das Zellenfeld. Bei herkömmlichen Leistungshalbleiterbauelementen genügt zumeist die Erwärmung des Halbleitermaterials, um ein positiv-differentielles Strom/Spannungsverhalten zu gewährleisten. Auch dynamische Dotierungseffekte, bei welchen beispielsweise Mobilladungsträger aus dem Durchbruchstrom in ihrer Wirkung der Hintergrunddotierung aufzurechnen sind, können eine derartige Charakteristik ermöglichen.

Jedenfalls sollte das Leistungshalbleiterbauelement im Fall eines elektrischen Durchbruches ein positiv-differentielles Strom/Spannungsverhalten haben.

(c) Bei den MOS-Transistoren gibt es bekanntlich in jeder Zelle ein "Dreischichtsystem" aus Sourcezone, Body-Zone und Drainzone, das für im Durchbruch erzeugte Löcher als parasitärer Bipolartransistor wirken kann:

die Basis dieses Bipolartransistors wird dabei durch die p-leitende Wanne gebildet. Fällt nun in dieser Basis infolge des Löcherstromes eine Spannung im Bereich von etwa 0,7 V ab, so schaltet der Bipolartransistor durch und zieht ohne weitere Steuerungsmöglichkeit mehr und mehr Strom, bis schließlich das Leistungshalbleiterbauelement zerstört ist. Dieses Verhalten wird letztlich durch die negative Temperatur/Widerstandskennlinie für Bipolartransistoren bewirkt. Derartigen Effekten kann nun durch bauliche Vorkehrungen entgegengewirkt werden: eine sehr effektive Möglichkeit besteht darin, Querströme an der Oberfläche zu vermeiden, also den elektrischen Durchbruch möglichst tief und zentral unter jede Zelle zu verlegen. Mit anderen Worten, parasitäre Bipolareffekte sind soweit als möglich zu vermeiden.

Die europäische Patenfianmeldung EP-A-503605 beschreibt einen IGBT, in welchem die Schichtdicke der Innenzone so gewählt ist, dass die in der Innenzone erzeugte Raumladungszone an das Ende der Innenzone anstösst, bevor die durch die angelegte Sperrsspannung erzeugte Feldstärke eine kritische Grösse erreicht.

Es ist Aufgabe der vorliegenden Erfindung, ein vertikal aufgebautes Leistungshalbleiterbauelement zu schaffen, bei dem auf einfache Weise sichergestellt ist, daß das Auftreten eines elektrischen Durchbruches zuverlässig im Zellenfeld erfolgt.

Diese Aufgabe wird bei einem vertikal aufgebauten Leistungshalbleiterbauelement der eingangs genannten Art erfindungsgemäß dadurch gelöst, daß

- die Schichtdicke des Halbleiterkörpers zwischen einerseits dem pn-Übergang zwischen dem Halbleiterkörper und der Zone des anderen Leitungstyps und andererseits der zweiten Hauptoberfläche so gewählt ist, daß bei Anlegen einer maximal zulässigen oder knapp darüber liegenden Sperrspannung zwischen der ersten und der zweiten Elektrode die im Halbleiterkörper erzeugte Raumladungszone an die zweite Hauptoberfläche anstößt oder diese gerade berührt, bevor die durch die angelegte Sperrspannung erzeugte Feldstärke die kritische Größe $E_c$ erreicht.

Dieser Bemessungsvorschrift für die Schichtdicke des Halbleiterkörpers zwischen dem pn-Übergang und der zweiten Hauptoberfläche liegen die folgenden Überlegungen zugrunde:

Wird im ausgeschalteten Zustand des Leistungshalbleiterbauelementes die beispielsweise zwischen Source und Drain anliegende Spannung schrittweise erhöht, so breitet sich die Raumladungszone ausgehend vom pn-Übergang zwischen der p-leitenden Wanne und der Drainzone immer weiter in den n-leitenden Bereich der Drainzone aus. Stößt nun die Raumladungszone an kristallgestörte oder nichtkristalline selbstleitende Bereiche, so werden von diesen Bereichen Elektron-Loch-Paare emittiert, wobei gemäß dem Potentialgefälle die Löcher durch die Raumladungszone zur ersten Hauptoberfläche bzw. Vorderseite und die Elektronen zur zweiten Hauptoberfläche bzw. Rückseite des Halbleiterkörpers abfließen. Dieser Effekt erhöht den Sperrstrom und ist eigentlich als "Parasit" anzusehen. Steigt nun allerdings der Sperrstrom mit kleiner Spannungsänderung sehr stark an, erreicht also die Raumladungszone einen sehr großflächigen kristallgestörten Bereich, so kann dies als Durchbruch genutzt werden. Genau dieser Effekt wird nun durch die vorliegende Erfindung ausgenutzt:

Die Schichtdicke des Halbleiterkörpers, also letztlich die Chipdicke, wird so gewählt, daß die Raumladungszone an die metallisierte zweite Hauptoberfläche anstößt, noch bevor die kritische Feldstärke $E_c$ im Volumen des Halbleiterkörpers erreicht wird. Es ist aber an sich ausreichend, wenn die Raumladungszone die zweite Hauptoberfläche bei Erreichen der kritischen Feldstärke gerade berührt bzw. bei deren knappem Überschreiten an diese anstößt. Von der auf der zweiten Hauptoberfläche vorgesehenen Metallisierung der zweiten Elektrode werden dann Löcher in das Volumen des Halbleiterkörpers emittiert, wodurch die Bedingungen für einen "Punch-Through" gegeben sind. Die den Löchern zugehörigen Elektronen gelangen dann von der Metallisierung der zweiten Hauptoberfläche über die äußere Beschaltung zur Spannungsquelle, welche die Sperrspannung an Source und Drain anlegt.

Mit diesem Punch-Through-Durchbruch wird zwar die Sperrspannung des Leistungshalbleiterbauelementes erniedrigt. Bei geeigneter Auslegung ergeben sich aber zahlreiche Vorteile, mit denen das Avalancheverhalten optimiert werden kann:

(a) Der Durchbruch erfolgt zuverlässig und definiert auf der zweiten Hauptoberfläche bzw. Rückseite des Leistungshalbleiterbauelementes, also in "weiter Entfernung" von den oberflächennahen parasitären Bipolartransistoren. Da die im Durchbruch erzeugten Löcher dem Potentialgradienten folgen, fließen sie senkrecht zur ersten Hauptoberfläche, also senkrecht zur Chipvorderseite. Nahe der ersten Hauptoberfläche ist das elektrische Feld infolge der p-leitenden Wannen so verzerrt, daß sogar ein "Trichtereffekt" des elektrischen Feldes in Richtung auf Kontaktlöcher auftritt, die in der ersten Hauptoberfläche vorgesehen sind.

Damit können oberflächennahe horizontal fließende elektrische Ströme im Bereich der ersten Hauptoberfläche praktisch vollkommen ausgeschlossen werden.

Vorkehrungen, die bei üblichen Leistungshalbleiterbauelementen gegen den parasitären Bipolareffekt gewöhnlich getroffen werden müssen, können somit entfallen.

(b) Mittels oberflächenpositionierter Feldplatten wird die Raumladungszone gewöhnlich am Rand des Halbleiterkörpers zur ersten Hauptoberfläche bzw. Vorderseite hin hochgezogen und mündet spätestens an einem sogenannten "Channelstopper" bzw. Kanalstopper in ein auf dieser Hauptoberfläche vorgesehenes Vorderseitenoxid. Unter Ausnutzung des Punch-Through-Effektes wird aber der Durchbruch automatisch unter dem Zellenfeld festgelegt, da dort die Raumladungszone tiefer reicht und damit bei kleineren Spannungen vor Bereichen unterhalb des Randes des Halbleiterkörpers bereits an die Metallisierung der zweiten Hauptoberfläche anstößt.

(c) Die Höhe der Durchbruchspannung ergibt sich vorrangig aus der Geometriegröße "Schichtdicke des Halbleiterkörpers" bzw. "Chipdicke" und nicht wie bei bisherigen Leistungshalbleiterbauelementen aus der vom Material abhängigen kritischen Feldstärke $E_c$. Dies bietet vor allem Vorteile bei sogenannten Kompensationsbauelementen, deren Durchbruchspannung in der Regel parabolisch von der Ladungsbilanz im Halbleitervolumen, also auch von Fertigungsschwankungen abhängt. Mit der Ausnutzung des Punch-Through-Effektes wird hier der Durchbruch "festgeklemmt", was zu einer Abflachung der sogenannten Kompensationsparabel und damit zu einer Homogenisierung der Abhängigkeit des Durchbruches vom Material führt.

Die Herstellung des erfindungsgemäßen vertikal aufgebauten Leistungshalbleiterbauelementes kann relativ einfach erfolgen:

Nach der sogenannten Vorderseitenprozessierung auf der ersten Hauptoberfläche wird der Wafer mit den einzelnen Chips bzw. Halbleiterkörpern zunächst auf eine Waferstärke gedünnt, die gemäß der Auslegung der beabsichtigten Leistungshalbleiterbauelemente einen Durchgriff der Raumladungszone zur Rückseite erlaubt. Hierfür können Dünnscheibentechnologien eingesetzt werden, wie sie nach dem derzeitigen Stand der Technik bekannt sind (vgl. T. Laska, M. Matschitsch, K. Scholtz: "Ultrathin wafer technology for a new 600 V IGBT", ISRSD '97, Seiten 361-364).

Zwar ist das Dünnen eines Wafers mit Zusatzkosten verbunden; diese können aber "neutralisiert" werden: bei Verwendung von nicht gedünnten Wafern muß unterhalb des höherohmigen Halbleitervolumens, das für den Spannungsabbau im Sperrfall dient, ein hochdotiertes Substrat positioniert sein. Dieses erfüllt keine zwingende elektrische Funktion; es dient gewissermaßen als Trägermaterial, das im durchgeschalteten Zustand so wenig wie möglich zum Einschaltwiderstand beitragen soll und gegebenenfalls als Feldstoppzone verwendet wird. Derartige Wafer sind aber sehr teuer, da die spannungsaufnehmende Schicht durch einen aufwendigen Epitaxieprozeß auf das Trägermaterial aufgebracht wird. Bei der Dünnscheibentechnologie wird nun ein solches niederohmiges Trägermaterial nicht mehr benötigt, so daß mit wenig aufwendigen Substratwafern gearbeitet werden kann.

Neben Bereichen der zweiten Hauptoberfläche, also den Rückseitenbereichen, über die der Raumladungszonen-Durchgriff erfolgt und die deshalb relativ niedrig dotiert sein müssen, den sogenannten Durchgriffbereichen, müssen auch Gebiete definiert werden, die für einen guten Kontakt zur Metallisierung sorgen, also niederohmig sind. Durchgriffbereiche müssen also abwechselnd mit Anschlußbereichen vorgesehen werden.

Die Dotierungskonzentration für die Durchgriffbereiche ergibt sich aus der Dotierung des Halbleiterkörpers, also der Substratdotierung, oder läßt sich auch über eine ganzflächige Rückseitenimplantation verändern. Der Einbau einer schwachen Feldstoppschicht kann gegebenenfalls von Vorteil sein, um die Sperrspannung des Leistungshalbleiterbauelementes zu erhöhen (vgl. DE 197 31 495 C2).

Zur Definition der niederohmigen Anschlußbereiche muß die zweite Hauptoberfläche strukturiert werden. Dies kann beispielsweise mittels Implantation über eine Photoresistmaske erfolgen. Durch entsprechende Einstellung des Flächenverhältnisses "Anschlußbereich/Durchgriffbereich" läßt sich die Löcherinjektion im Punch-Through-Durchbruch und damit die Strom/Spannungscharakteristik im Durchbruch steuern. Das Homogenisierungsverhalten des Durchbruches über die zweite Hauptoberfläche läßt sich somit gezielt beeinflussen, und der Punkt in der Strom/Spannungskennlinie, ab dem sich ein negativ-difierentielles Verhalten ergibt, der sogenannte "Snap-Back"-Punkt läßt sich optimieren.

Oben wurde erläutert, daß die Raumladungszone bei einem Punch-Through-Durchbruch unmittelbar an die Metallisierung der zweiten Hauptoberfläche angrenzt, was bedeutet, daß die Dünnscheibentechnologie eingesetzt werden muß. Alternativ gibt es aber die Möglichkeit, die Raumladungszone auf eine p-dotierte Schicht an der zweiten Hauptoberfläche anstelle auf die Metallisierung durchgreifen zu lassen. Damit wirkt diese p-leitende Schicht als Löcherinjektor. Mit dieser Methode ist es möglich, entsprechend der Auslegung der p-leitenden Schicht zu dickeren Halbleiterkörpern bzw. Scheiben überzugehen. Nachteilhaft an diesem Vorgehen ist aber, daß im durchgeschalteten, nicht ausgeräumten Zustand die p-leitende Schicht als Kollektor wirkt, so daß sich der Leistungstransistor ähnlich wie ein IGBT verhält. Mit anderen Worten, typische Kenngrößen für einen MOS-Transistor können stark beeinflußt werden.

Nachfolgend wird die Erfindung anhand der Zeichnungen näher erläutert. Es zeigen:

Fig. 1     ein schematisches Diagramm des erfindungsgemäßen vertikal aufgebauten Leistungshalbleiterbauelements,

Fig. 2     eine vergrößerte Darstellung des Bereiches der zweiten Hauptoberfläche bei diesem Leistungshalbleiterbauelement,

Fig. 3     den Verlauf von Äquipotentiallinien unter dem Randabschluß bei dem erfindungsgemäßen Leistungshalbleiterbauelement,

Fig. 4     einen schematischen Schnitt durch ein Kompensationsbauelement und

Fig. 5     einen Randabschluß für ein Komepnsationsbauelement.

Wie bereits eingangs erwähnt wurde, wird die Erfindung anhand eines n-Kanal-MOS-Leistungstransistors mit vertikalem Aufbau beschrieben. Die Erfindung ist jedoch nicht hierauf begrenzt. Bei Umkehrung der Leitungstypen kann in gleicher Weise selbstverständlich auch ein p-Kanal-MOS-Transistor hergestellt werden. Ebenso kann die Erfindung auch bei anderen Bauelementen, beispielsweise IGBTs, eingesetzt werden.

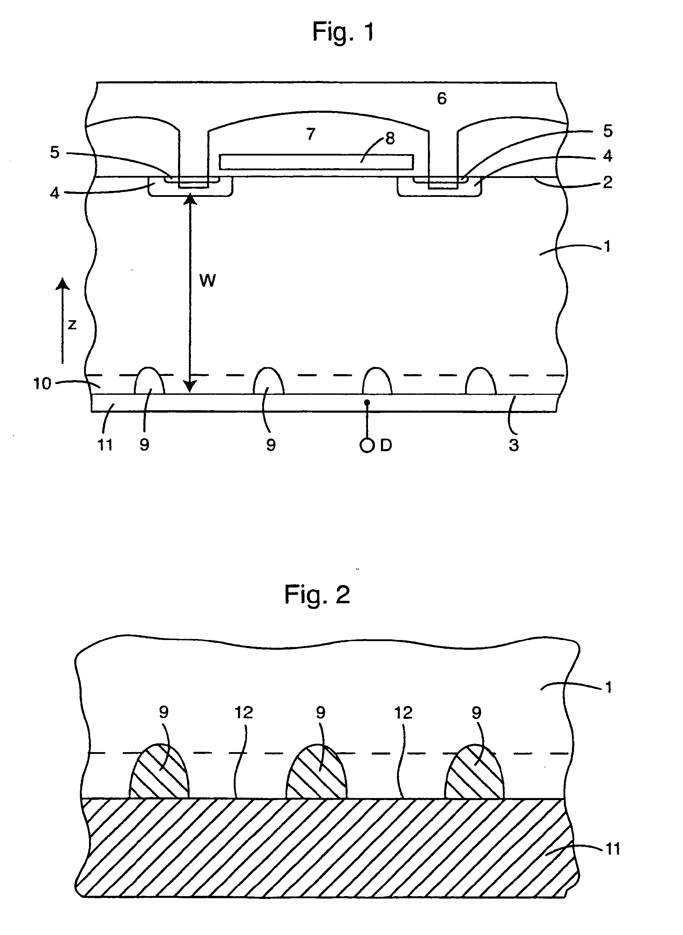

Fig. 1 zeigt einen $n^-$-leitenden Halbleiterkörper mit einer ersten Hauptoberfläche 2 und einer zweiten Hauptoberfläche 3. Im Bereich der ersten Hauptoberfläche 2, der Vorderseite, sind p-leitende Wannen- bzw. Body-Zonen 4 eingebracht, die ihrerseits $n^+$-leitende Source-Zonen 5 enthalten. Die Source-zonen 5 sind mit einer Source-Metallisierung 6 versehen, die im wesentlichen auf einer aus Siliziumdioxid bestehenden Isolierschicht 7 verläuft, in welche eine Gateelektrode 8 im Bereich oberhalb der Body-Zone 4 eingebracht ist.

Im Bereich der zweiten Hauptoberfläche 3 sind $n^+$-leitende Anschlußgebiete 9 vorgesehen, welche einen elektrisch guten Kontakt zu einer Rückseitenmetallisierung 11 aus beispielsweise Aluminium herstellen, die als Drainelektrode D auf die zweite Hauptoberfläche 3 bzw. Rückseite des Halbleiterkörpers 1 aufgebracht ist. Gegebenenfalls kann noch eine n-leitende Schicht 10 im Bereich der Rückseite angeordnet werden.

Fig. 2 zeigt in einem vergrößerten Maßstab die Rückseite des Leistungshalbleiterbauelementes von Fig. 1. Aus dieser Figur sind speziell die Anschlußbereiche 9 und Durchgriffbereiche 12 zu ersehen, deren Flächenverhältnis die Löcherinjektion im Punch-Through-Durchbruch festlegt und damit eine Steuerung der Strom/Spannungscharakteristik im Durchbruch erlaubt.

Die Schichtdicke W des Halbleiterkörpers 1 zwischen einerseits dem pn-Übergang zwischen dem Halbleiterkörper 1 und der Body-Zone 4 und andererseits der zweiten Hauptoberfläche 3 ist so gewählt, daß bei Anliegen der Sperrspannung zwischen der Source-Metallisierung 6 und der Drainelektrode D die im Halbleiterkörper erzeugte Raumladungszone an die zweite Hauptoberfläche 3 anstößt, bevor die durch die angelegte Sperrspannung erzeugte Feldstärke die kritische Größe $E_c$ erreicht.

Diese kritische Größe $E_c$ der Feldstärke ist über die Maxwell'sche Gleichung

$$\vec{\nabla} \cdot \vec{E} = -4\pi\rho \qquad\qquad (1)$$

mit der Ladungsdichte p verknüpft, so daß sich eine Beziehung zu einer kritischen Durchbruchladung $q_c$ herstellen läßt:

$$\int_{o}^{w} \rho(z)\,dz = q_c \qquad\qquad (2)$$

Erfindungsgemäß soll nun die Schichtdicke so gewählt sein, daß die Raumladungszone die zweite Hauptoberfläche 3 erreicht, bevor die Feldstärke die kritische Größe $E_c$ annimmt. Mit anderen Worten, das Integral von Gleichung (2) soll beispielsweise höchstens den Wert von 0,9 $q_c$ erreichen, so daß in dem erfindungsgemäßen vertikal aufgebauten Leistungshalbleiterbauelement die folgende Beziehung erfüllt ist:

$$\int_{o}^{w} \rho(z)\,dz \le 0,9\ q_c \qquad\qquad (3)$$

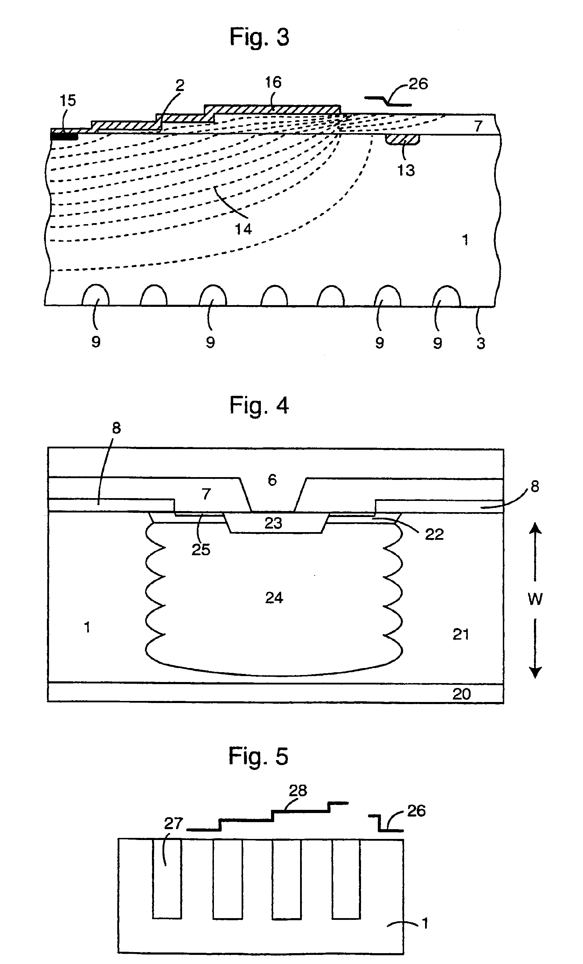

Fig. 3 zeigt einen Randabschluß eines Leistungshalbleiterbauelementes mit einer $p^+$-leitenden Zone 15, einer Source-Feldplatte 16 und einem mit einer Feldplatte 26 versehenen Channel-Stopper 13, der $n^+$-dotiert ist. Der Halbleiterkörper 1 ist wie in dem obigen Ausführungsbeispiel $n^-$-leitend. Außerdem ist aus der Fig. 3 der Verlauf von Äquipotentiallinien 14 zu ersehen.

Wie in Fig. 3 gezeigt ist, wird bei dem erfindungsgemäßen Leistungshalbleiterbauelement der Durchbruch unterhalb des Zellenfeldes fixiert, da dort die Raumladungszone (vgl. die Äquipotentiallinien 14) tiefer reicht und damit bei kleineren Spannungen bereits an die Metallisierung auf der zweiten Hauptoberfläche 3 anstößt, bevor dies für Bereiche unterhalb des Randes zutrifft.

Fig. 4 zeigt schematisch ein Kompensationsbauelement, bei dem auf einem $n^+$-leitenden Substrat 20 eine n-leitende epitaktische Schicht 21 vorgesehen ist, in welcher sich eine p-leitende Wanne 22, eine $p^+$-leitende Body-Zone 23 und eine $n^+$-leitende Source-Zone 25 befinden. Außerdem ist zur "Kompensation" eine p-leitende "Säule" 24 vorgesehen, die beispielsweise durch mehrere Epitaxien, verbunden mit Implantationen, hergestellt wird.

Bei diesem Leistungshalbleiterbauelement werden im aktiven Volumen unterhalb der Source-Metallisierung 6 vertikal verlaufende p-leitende und n-leitende Gebiete, sogenannte "Säulen", nebeneinander angeordnet. Im durchgeschalteten Zustand ergibt sich dadurch ein nicht unterbrochener niederohmiger Leitungspfad vom Sourceanschluß bzw. der Metallisierung 6 zum Drainanschluß bzw. dem $n^+$-leitenden Substrat 20.

Jedes der beiden Ladungsgebiete oder "Säulen" darf in Horizontalrichtung gesehen nur einen Bruchteil der Durchbruchsflächenladung beinhalten, so daß die horizontale Flächenladung kleiner als die kritische Ladung $q_c$ ist. Im Sperrfall wird die Spannung von dem Leistungshalbleiterbauelement dadurch aufgenommen, daß sich die nebeneinander liegenden p-leitenden Gebiete und n-leitenden Gebiete gegenseitig ausräumen. Mit anderen Worten, die Ladungsträger des einen Gebietes "kompensieren" elektrisch diejenigen des entgegengesetzt geladenen Gebietes. Dies bewirkt in den einzelnen Ebenen bei kleinen Spannungen ein vorwiegend horizontal gerichtetes elektrisches Feld.

Mit steigender Spannung zwischen Source und Drain wird ein anwachsender Teil des Volumens horizontal ausgeräumt, bis mindestens eine der beiden nebeneinander angeordneten "Säulen" an Ladungsträgern vollständig verarmt ist. Das horizontale elektrische Feld $E_h$ hat dann einen Maximalwert $E_{Bh}$ erreicht. Bei weiterer Steigerung der Spannung beginnt die Ausräumung des $n^+$-leitenden Substrates 20 bzw. von tieferliegenden ganzflächigen epitaktischen Schichten oder der p-leitenden Wanne 22, so daß sich nunmehr ein vertikales elektrisches Feld $E_v$ aufbaut.

Der Durchbruch ist erreicht, wenn das vertikale Feld einen Wert $E_{Bv}$ erreicht, für den gilt:

$$E_c = \left|\vec{E}_{Bv} + \vec{E}_{Bh}\right| \ \rightarrow\ E_{Bv} = \sqrt{E_c{}^2 - E_{Bh}{}^2} \qquad\qquad (4)$$

Bei entsprechenden Abmessungen der einzelnen Zellen wird selbst bei hohen Dotierungen der Säulen, was

einen niedrigen Einschaltwiderstand $R_{on}$ bedeutet, das horizontale Feld $E_{Bh}$ nur relativ geringe Werte annehmen, so daß das vertikale Feld $E_{Bv}$ in der Größenordnung von $E_c$ liegt. Dies bedeutet, daß ein derartiges Kompensationsbauelement trotz eines niedrigen Einschaltwiderstandes $R_{on}$ hohe Spannungen zu sperren vermag.

Auch lassen sich Kompensationsbauelemente bei geeigneter Auslegung der Dotierverhältnisse in den Säulen so gestalten, daß zwischen Sperrspannung und Einschaltwiderstand praktisch eine lineare Abhängigkeit besteht.

Die Anwendung der vorliegenden Erfindung auf Kompensationsbauelemente eröffnet für diese besondere Vorteile:

Da der Punch-Through-Durchbruch im Zellenfeld und nicht im Rand erfolgt, kann die Forderung eliminiert werden, daß der Rand mehr Spannung sperren muß als das Zellenfeld. Damit kann die Struktur des Zellenfeldes bis zu dem Rand unverändert fortgesetzt werden. Das heißt, die Implantationsöffnungen in den einzelnen epitaktischen Schichten brauchen sich zwischen dem Zellenfeld und dem Rand nicht mehr zu unterscheiden, wie dies bei bisher üblichen Kompensationsbauelementen der Fall ist.

Ein bevorzugtes Anwendungsgebiet der Erfindung sind also Kompensationsbauelemente, bei denen in den beispielsweise n-leitenden Halbleiterkörper 1 säulenartige, vertikal verlaufende und p-dotierte Kompensationsgebiete 27 (entsprechend der "Säule" 24) eingelagert sind. Eine Randstruktukr hierfür mit einer Feldplatte 28 und der Channel-Stopper-Feldplatte 26 ist in Fig. 5 gezeigt.

Vorteilhaft ist bei der vorliegenden Erfindung auch der Umstand, daß bei einem Durchbruch im Bereich der zweiten Hauptoberfläche bzw. Rückseite ausschließlich Löcher in das Halbleitervolumen injiziert werden. Diese zeigen aber ein wesentlich schwächeres Multiplikationsvermögen als Elektronen, welche beim herkömmlichen Felddurchbruch neben den Löchern im Halbleiterkörper erzeugt würden.

Bezugszeichenliste:

| | |
|---|---|
| 1 | Halbleiterkörper |
| 2 | erste Hauptoberfläche |
| 3 | zweite Hauptoberfläche |
| 4 | p-leitende Body-Zone |
| 5 | Sourcezone |
| 6 | Source-Metallisierung |
| 7 | Isolierschicht |
| 8 | Gateelektrode |
| 9 | Anschlußgebiet |
| 10 | n-leitende Zone |
| 11 | Drain-Metallisierung |
| 12 | Durchgriffbereich |
| 13 | Channel-Stopper |
| 14 | Äquipotentiallinien |
| 15 | $p^+$-leitende Zone |
| 16 | Source-Feldplatte |
| 20 | $n^+$-leitendes Substrat |
| 21 | n-leitende epitaktische Schicht |
| 22 | p-leitende Wanne |
| 23 | $p^+$-leitende Body-Zone |
| 24 | p-leitende Säule |
| 25 | $n^+$-leitende Source-Zone |
| 26 | Feldplatte |
| 27 | Kompensationsgebiete |
| 28 | Feldplatte |
| D | Drainelektrode |

**Patentansprüche**

**1.** Vertikal aufgebauter Leistungstransistor mit:

- einem eine erste Hauptoberfläche (2) und eine zur ersten Hauptoberfläche (2) gegenüberliegende zweite Hauptoberfläche (3) aufweisenden Halbleiterkörper (1) des einen Leitungstyps,
- einer in die erste Hauptoberfläche (2) eingebrachten Body-Zone (4) des anderen, zum einen Leitungstyp entgegengesetzten Leitungstyps,
- einer in der Body-Zone (4) vorgesehenen Zone (5) des einen Leitungstyps,
- einer die Zone (5) des einen Leitungstyps und die Body-Zone (4) kontaktierenden ersten Elektrode (6),
- einer auf der zweiten Hauptoberfläche (3) vorgesehenen zweiten Elektrode (11) und
- einer oberhalb der Body-Zone (4) angeordneten und von dieser durch eine Isolierschicht (7) getrennten Gateelektrode (8),

**dadurch gekennzeichnet , dass**

- die Schichtdicke w des Halbleiterkörpers (1) zwischen einerseits dem pn-Übergang zwischen dem Halbleiterkörper (1) und der Body-Zone (4) des anderen Leitungstyps und andererseits der zweiten Hauptoberfläche (3) so gewählt ist, dass bei einer spezifischen Ladungsdichte $\rho$ in einer Richtung z zwischen dem pn-Übergang und der zweiten Hauptoberfläche (3) die folgende Beziehung gilt:

$$\int_{0}^{w} \rho\,(z)\;dz\;\leq\;0{,}9\,q_c$$

in welcher $q_c$ die kritische Ladungsmenge im Halbleiterkörper (1) bedeutet, die mit dem zwischen der ersten und der zweiten Elektrode (6, 11) anliegenden elektrischen Feld ($E_z$) durch die Maxwell'sche Gleichung

$$\overline{\nabla}\cdot\overline{E}_z\;=\;-\,4\pi\rho$$

verknüpft ist, so dass bei Anlegen einer maximal zulässigen oder knapp darüber liegenden Sperrspannung zwischen der ersten und der zweiten Elektrode (6 bzw. 11) die im Halbleiterkörper (1) erzeugte Raumladungszone an die zweite Hauptoberfläche (3) anstößt oder diese gerade berührt, bevor das durch die angelegte Sperrspannung erzeugte elektrische Feld ($E_z$) eine kritische Feldstärke $E_c$ erreicht, und

- der Halbleiterkörper (1) an der zweiten Hauptoberfläche (3) hochdotierte Anschlussbereiche (9) des einen Leitungstyps aufweist, so dass
über das Flächenverhältnis zwischen den Anschlussbereichen (9) einerseits und zwischen diesen Anschlussbereichen (9) freiliegenden Durchgriffbereichen (12) des Halbleiterkörpers (1) zur zweiten Elektrode (11) andererseits die Strom-/Spannungscharakteristik im Durchbruch steuerbar ist.

2. Vertikal aufgebauter Leitungstransistor nach Anspruch 1,
   **gekennzeichnet durch**
   eine Zone (10) des einen Leitungstyps im Bereich der zweiten Hauptoberfläche (3).

3. Vertikal aufgebauter Leistungstransistor nach Anspruch 1 oder 2,
   **gekennzeichnet durch**
   einen mit einem Channelstopper (13, 26) versehenen Randabschluss.

4. Vertikal aufgebauter Leistungstransistor nach Anspruch 3,
   **gekennzeichnet durch**
   eine Sourcefeldplatte (16).

5. Vertikal aufgebauter Leistungstransistor nach einem der Ansprüche 1 bis 4,
   **dadurch gekennzeichnet, dass**
   unterhalb der Body-Zone (23) im Halbleiterkörper (21) ein Kompensationsbereich (24) des anderen Leitungstyps vorgesehen ist.

6. Vertikal aufgebauter Leistungstransistor nach Anspruch 5,
**dadurch gekennzeichnet, dass**
der Bereich (24) des anderen Leitungstyps über mehrere Epitaxie- und Implantationsschritte hergestellt ist.

7. Vertikal aufgebauter Leistungstransistor nach Anspruch 6,
**dadurch gekennzeichnet, dass**
der Bereich (24) des anderen Leitungstyps horizontal zwischen der ersten und der zweiten Hauptoberfläche (2, 3) durch gleiche Implantationsöffnungen hergestellt ist.

8. Vertikal aufgebauter Leistungstransistor nach einem der Ansprüche 1 bis 7,
**dadurch gekennzeichnet, dass**
der Halbleiterkörper (1) insbesondere in seinem Rand mit vertikalen Kompensationsgebieten (27) des anderen Leitungstyps versehen ist.

## Claims

1. Vertically structured power transistor having:

   - a semiconductor body (1) of a first conduction type, having a first main surface (2) and a second main surface (3) opposite the first main surface (2),
   - a body zone (4) of the other conduction type, the opposite of the first conduction type, which is introduced into the first main surface (2),
   - a zone (5) of the first conduction type, which is provided in the body zone (4),
   - a first electrode (6), which makes contact with the zone (5) of the first conduction type and with the body zone (4),
   - a second electrode (11), which is provided on the second main surface (3), and
   - a gate electrode (8), which is arranged above the body zone (4) and is separated from the latter by an insulating layer (7),

   **characterized in that**

   - the layer thickness w of the semiconductor body (1) between, on the one hand, the pn junction between the semiconductor body (1) and the body zone (4) of the other conduction type and, on the other hand, the second semiconductor surface (3) is selected in such a way that, the following equation is satisfied with a specific charge density $\rho$ in a direction z between the pn junction and the second main surface (3):

   $$\int_0^w \rho(z)dz \le 0.9 q_c$$

   in which $q_c$ denotes the critical charge quantity in the semiconductor body (1), which is linked to the electric field ($E_z$) applied between the first electrode and the second electrode (6, 11) by the Maxwell equation: $\overline{\nabla}.\overline{E} = -4\pi\rho$ , so that when a maximum allowed blocking voltage, or a voltage just less than this, is applied between the first and second electrodes (6 and 11, respectively), the space charge zone created in the semiconductor body (1) meets the second main surface (3), or just touches it, before the electric field ($E_z$) created by the applied blocking voltage reaches a critical field strength $E_c$, and

   - the semiconductor body (1) has heavily doped terminal regions (9) of the first conduction type at the second main surface (3), so that
   the current/voltage characteristic in breakdown can be controlled through the area ratio between the terminal regions (9), on the one hand, and punch-through regions (12) - exposed between said terminal regions (9) - of the semiconductor body (1) to the second electrode (11), on the other hand.

2. Vertically structured power transistor according to Claim 1, **characterized by** a zone (10) of the first conduction type in the vicinity of the second main surface (3).

3. Vertically structured power transistor according to Claims 1 or 2, **characterized by** an edge termination provided with a channel stopper (13, 26).

4. Vertically structured power transistor according to Claim 3, **characterized by** a source magnetoresistor (16).

5. Vertically structured power transistor according to one of Claims 1 to 4, **characterized in that** a compensation region (24) of the other conduction type is provided below the body zone (23) in the semiconductor body (21).

6. Vertically structured power transistor according to Claim 5, **characterized in that** the region (24) of the other conduction type is produced by a plurality of epitaxy and implantation operations.

7. Vertically structured power transistor according to Claim 6, **characterized in that** the region (24) of the other conduction type is produced horizontally between the first and second main surfaces (2, 3) through the same implantation openings.

8. Vertically structured power transistor according to one of Claims 1 to 7, **characterized in that** the semiconductor body (1) is provided, especially in its edge, with vertical compensation areas (27) of the other conduction type.

**Revendications**

1. Transistor de puissance à structure verticale, comprenant :

- un corps (1) semiconducteur d'un type de conductivité ayant une première surface (2) principale et une deuxième surface (3) principale opposée à la première surface (2) principale,
- une zone (4) de corps introduite dans la première surface (2) principale ayant l'autre type de conductivité opposé au un type de conductivité,
- une zone (5) du un type de conductivité prévue dans la zone (4) de corps,
- une première électrode (6) en contact avec la zone (5) du un type de conductivité et avec la zone (4) de corps,
- une deuxième électrode (11) prévue sur la deuxième surface (3) principale et
- une électrode (8) de grille disposée au-dessus de la zone (4) de corps et séparée de celle-ci par une couche (7) isolante,

**caractérisé en ce que**

- l'épaisseur w de couche du corps (1) semiconducteur entre, d'une part, la jonction pn entre le corps (1) semiconducteur et la zone (4) de corps de l'autre type de conductivité et, d'autre part, la deuxième surface (3) principale est choisie de manière à ce que, pour une densité p de charge spécifique dans une direction z entre la jonction pn et la deuxième surface (3) principale, on ait la relation suivante :

$$\int_0^w \rho\,(z)\,dz \le 0{,}9\,q_c$$

dans laquelle $q_c$ est la quantité de charge critique dans le corps (1) semiconducteur, qui est reliée au champ ($E_z$) électrique s'appliquant entre la première et la deuxième électrodes (6, 11) par l'équation de Maxwell

$$\overline{\nabla}\cdot\overline{E_z} = -4\pi\rho$$

de sorte que, si on applique une tension de blocage maximum admissible ou juste au-dessus entre la première et la deuxième électrodes (6 et 11), la zone de charge d'espace produite dans le corps (1) semiconducteur vient sur la deuxième surface (3) principale ou la touche exactement avant que le champ ($E_z$) électrique produit par la tension de blocage appliqué n'atteigne une intensité $E_c$ de champ critique, et

- le corps (1) semiconducteur a sur la deuxième surface (3) principale des parties (9) de borne très dopées du un type de conductivité, de sorte que la caractéristique courant-tension au claquage peut être réglée par le rapport de surface entre les parties (9) de borne, d'une part, et entre des parties (12) à nu entre ces parties (9) de borne du corps (1) semiconducteur de passage vers la deuxième électrode (11).

2. Transistor de puissance à structure verticale suivant la revendication 1,
   **caractérisé par**
   une zone (10) du un type de conductivité dans la partie de la deuxième surface (3) principale.

3. Transistor de puissance à structure verticale suivant la revendication 1 ou 2,
   **caractérisé par**
   une terminaison de bord munie d'un stoppeur channel (13, 26).

4. Transistor de puissance à structure verticale suivant la revendication 3,
   **caractérisé par**
   une plaque (16) de champ de source.

5. Transistor de puissance à structure verticale suivant l'une des revendications 1 à 4,
   **caractérisé en ce que**
   il est prévu une partie (24) de compensation de l'autre type de conductivité en dessous de la zone (23) de corps dans le corps (21) semiconducteur.

6. Transistor de puissance à structure verticale suivant la revendication 5,
   **caractérisé en ce que**
   la partie (24) de l'autre type de conductivité est produite par plusieurs stades d'épitaxie et d'implantation.

7. Transistor de puissance à structure verticale suivant la revendication 6,
   **caractérisé en ce que**
   la partie (24) de l'autre type de conductivité est produite horizontalement entre la première et la deuxième surfaces (2, 3) principales par de mêmes ouvertures d'implantation.

8. Transistor de puissance à structure verticale suivant l'une des revendications 1 à 7,
   **caractérisé en ce que**
   le corps (1) semiconducteur est muni, notamment dans son bord, de régions (27) verticales de compensation de l'autre type de conductivité.

## Fig. 1

## Fig. 2

## Fig. 3

## Fig. 4

## Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 503605 A

- DE 19731495 C2

### In der Beschreibung aufgeführte Nicht-Patentliteratur

- **T. Laska ; M. Matschitsch ; K. Scholtz.** Ultrathin wafer technology for a new 600 V IGBT. *ISRSD '97,* 361-364